Europäisches Patentamt

(19) European Patent Office

Office européen des brevets

(11) Publication number: **0 076 810**
**B1**

(12) **EUROPEAN PATENT SPECIFICATION**

(45) Date of publication of patent specification: **04.11.87**

(21) Application number: **82901065.1**

(22) Date of filing: **19.02.82**

(86) International application number:
**PCT/US82/00205**

(87) International publication number:
**WO 82/02975 02.09.82 Gazette 82/21**

(51) Int. Cl.⁴: **G 09 G 3/04**

(54) **MULTI-FORMAT DATA DISPLAY APPARATUS.**

(30) Priority: **26.02.81 US 238477**

(43) Date of publication of application:
**20.04.83 Bulletin 83/16**

(45) Publication of the grant of the patent:
**04.11.87 Bulletin 87/45**

(84) Designated Contracting States:
**CH DE FR GB LI**

(56) References cited:
**US-A-3 388 380**
**US-A-3 932 859**
**US-A-4 122 444**
**US-A-4 153 950**
**US-A-4 161 719**
**US-A-4 205 200**

**No relevant documents have been disclosed**

(73) Proprietor: **GENERAL ELECTRIC COMPANY**
**1 River Road**
**Schenectady New York 12305 (US)**

(72) Inventor: **DI MASSIMO, Donald Vincent**
**7357 Westgate Lane**
**Liverpool, NY 13088 (US)**
Inventor: **LEMMON, Michael David**
**113 Richardson Drive**
**No. Syracuse, NY 13212 (US)**
Inventor: **MAY, John Bruce**
**3935 Willowbrook Lane**
**Liverpool, NY 13088 (US)**

(74) Representative: **Sanders, Peter Colin**
**BROOKS & MARTIN High Holborn House**
**52/54 High Holborn**
**High Holborn**
**London WC1V 6SE (GB)**

Courier Press, Leamington Spa, England.

# Description

This invention relates to data display apparatus and more particularly to systems for displaying data in various formats. The invention is especially useful in connection with the display of data relating to the metering of electrical energy.

Prior multi-format data displays include those having cathode-ray tubes for displaying selected data in selectable formats, hard copy printers, which also can display requested data in selectable formats, and customized displays developed for particular applications. These prior art multiple format displays are usually complex and expensive.

Therefore, a need exists for an inexpensive display which is capable of displaying data in various formats, and preferably for various lengths of display time. In addition, a need exists for a display which is capable of accepting data in different formats and reformating this data to the desired display format. The aforementioned needs are met by the present invention which provides an inexpensive variable format display.

In carrying out the invention, there is provided a multi-format data display apparatus comprising means for accepting data words in the form of a series of asynchronous digital data bits, each data word including a synchronization code portion comprising a predetermined pattern of serial data bits and a variable length message portion, means for separately storing separate segments of said message portion including a message length indicating segment and a format code segment and a variable length data segment; means for recognising said predetermined sync code patterns; first register means for storing said message portion after recognising said predetermined sync code pattern; means for decoding the format code segment of said stored message portions; characterized by the provision of second register means for storing preselected constants contained in the data segment of a stored message portion having a first predetermined format code; third register means for storing data to be displayed; means for formatting data contained in the data segment of a stored message portion having another predetermined format code which is different from said first format code, said data format being determined by the value of said other format code; means for transferring said formatted data into said third register means; and means for displaying the formatted data stored in said third register means.

In the accompanying drawings:

Fig. 1 is a schematic diagram of a preferred embodiment of a multi-format display apparatus in accordance with the present invention.

Fig. 2 illustrates the preferred arrangement of the elements of a data word processed by the multi-format display apparatus of the present invention.

Fig. 3 illustrates the preferred arrangement of storage registers in a random access memory of the display controller 12.

Fig. 4 is a functional schematic representation of the display apparatus 10 of Fig. 1.

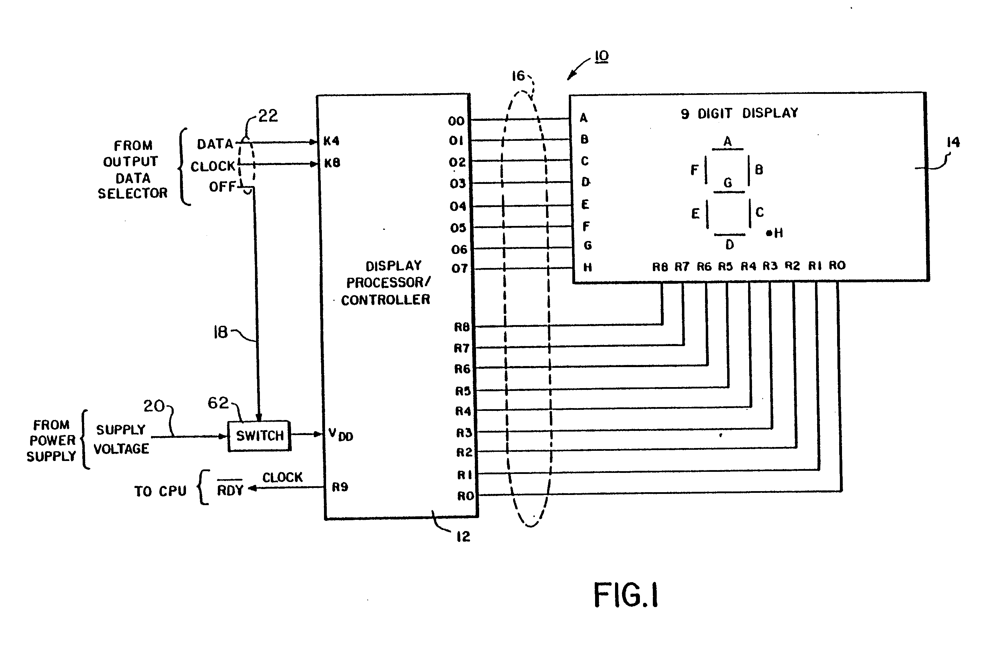

Referring to Fig. 1, there is shown a schematic diagram of the preferred embodiment of a multi-formant display apparatus of the present invention, generally designated 10. The display apparatus 10 comprises a display processor/controller 12 and a display device 14. In the preferred embodiment, the display processor/controller 12 is a Texas Instruments TMS 1070 microcomputer. The display device 14, is preferably a Futaba model number 9-ST-68 9-Digit Vacuum Fluorescent Display.

The outputs 00 through 07 of the display processor/controller 12 are electrically connected to the segment control inputs A through H respectively of the display device 14 by means of eight electrical conductors in a display control bus 16. The outputs R0 through R8 of the processor/controller 12 are electrically connected to the digit control inputs R0 through R8 respectively of the display device 14 by means of nine electrical conductors of the display control bus 16. Serial asynchronous data is received through input terminal K4 of the display/controller 12. A clock signal is received through input terminal K8. A ready signal $\overline{RDY}$ is transmitted out from output terminal R9 of the display processor/controller 12. In the preferred embodiment, power to the display processor/controller 12 is remotely controlled by means of a signal applied at connection 18 to an electronic switch 62 which selectively controls the application of power from a power input terminal 20.

All data and control is applied through the three wire serial link 22 which is connected to the K4 and K8 inputs of the display processor/controller 12.

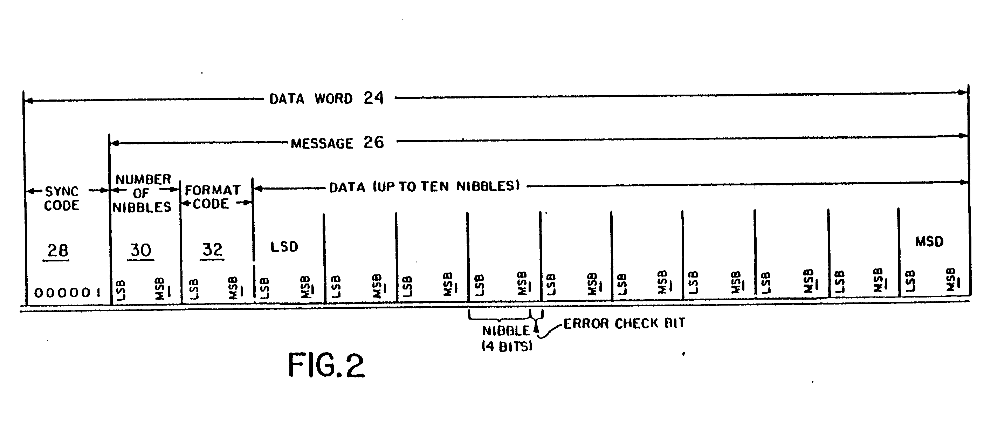

The preferred scheme for data transmission provides for error checking in case incorrect data is received. In Fig. 2, there is shown a preferred embodiment data word 24. The data word comprises a message 26 which is prefixed by a synchronization code which consists of 5 zeros followed by a 1 as indicated at 28. The message 26 comprises up to 12 nibbles or words, each nibble consisting of four bits of data followed by a 1. The display controller 12 checks for the 1 following the four data bits in each nibble and, if it is not received, begins looking for the sync code.

Within the position of each nibble the least significant bit position is marked by the letters LSB and the most significant bit position is marked by the letters MSB. Also in the data section of the message, the nibble corresponding to the least significant digit is marked with the letters LSD, and the nibble corresponding to the most significant digit is marked with the letters MSD.

The first nibble 30 of the message contains data which sets forth the number of nibbles in the message minus 1. The next nibble 32 contains a format code which tells the controller 12 what is to be done with the data received. Since there are four data bits in the format code nibble, there are sixteen possible format codes of which twelve are used. The format codes of the preferred embodi-

ment are as follows:

| Format code | Display type |
| --- | --- |
| 0 | Constants load |
| 1 | Display KH* |
| 2 | Blank Display |
| 3 | Message |
| 4 | Binary coded decimal Data |
| 5 | Meter ID (Identification) Number |
| 6 | Time |
| 7 | Kilowatt Hour |
| 8 | Date |
| 9 | Kilowatt Demand |
| 10 | Kilowatt Demand |
| 11 | Not Used |
| 12 | Not Used |
| 13 | Not Used |
| 14 | Not Used |
| 15 | Binary Data |

*KH is the calibration constant for the particular meter, its significance is explained subsequently

All unused format codes direct the controller 12 to data input requests in the communication link, as will be subsequently described in detail.

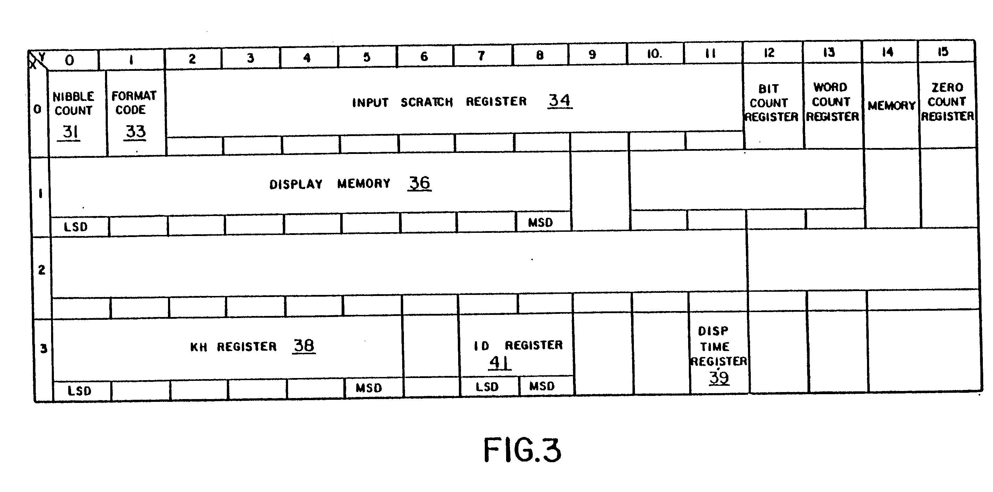

Referring now to Fig. 3, there is shown a map of storage registers in the random access memory of the controller 12. The random access memory preferably has a capacity of sixty-four words organized in four files, each file containing sixteen four bit words. A Y-register in the controller 12 selects one of the sixteen words in a file and an X-register selects one of the four sixteen word files. For purposes of clarity and ease in understanding the description, Fig. 3 depicts the memory map in matrix form, showing the files as X numbered rows and the words as Y numbered columns. Hereinafter, words are referred to as nibbles. The memory map depicted in Fig. 3 shows memory locations used for all processing with the exception of binary to binary coded decimal conversions and binary coded decimal multiplication. The memory maps associated with those functions are very similar and are not separately illustrated.

The individual memory files X0, X1, X2, and X3, and portions of those files, are sometimes referred to below as registers. For instance, within file X0, the nibble position Y0 constitutes a nibble count register 31 to indicate the length of the message, the nibble position Y1 constitutes a format code register 33, and the nibbles Y2 through Y11 constitute an input scratch register (temporary register) 34 for temporary data storage. In file X1, the nibbles Y0 through Y8 comprise a display memory register 36. In file X3, nibbles Y0 through Y5 constitute a KH register 38, and nibble 11 constitutes a dislpay time register 39.

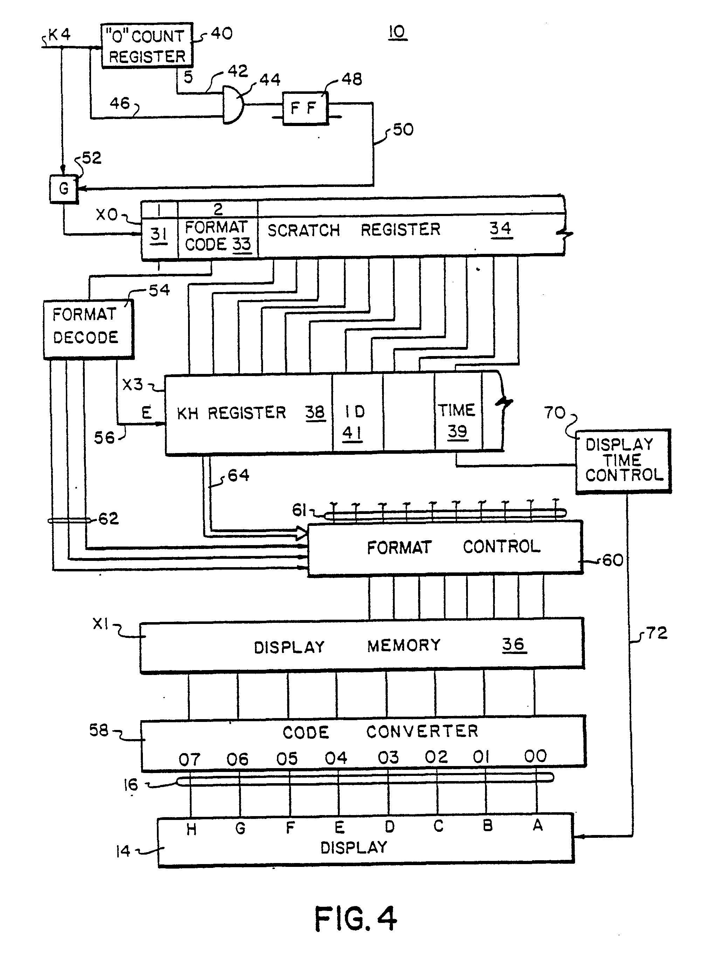

Fig. 4 is a functional schematic representation of the display apparatus 10, including a separate showing of some of the files and registers illustrated in Fig. 3.

The synchronization code 28 of a data word, as illustrated in Fig. 2, must be recognized by the system before the data word can be received and processed. As illustrated in Fig. 4, the incoming data on connection K4 is supplied to a "zero" count register 40. If the "zero" count register 40 detects five or more successive zeros from the input connection K4, it supplies an output signal at connection 42 to an AND gate 44. Another input to the AND gate 44 is provided through a connection 46 directly from the K4 input so that if the next succeeding input signal is a binary 1, and the synchronization code requirement of five zeros followed by a one has been fulfilled, the AND gate 44 is enabled, setting a flip-flop 48. The flip-flop 48 then operates through a connection 50 to enable a gate 52, which permits the data word to be stored in the file X0. As previously explained in connection with Fig. 3, file X0 includes the format code register 33, the nibble count register 31, and the scratch register 34.

The synchronization code recognition circuitry, just described, operates to process data pulse signals whenever they are received. The timing of the signals may be asynchronous (not synchronized with a clock within this apparatus). However, the synchronization (sync.) code timing determines the timing of the operation of the apparatus to receive and process the data in synchronization with timing of that data. The details of the clocking features have not been shown or described in order to simplify the presentation. The important principle is that, when the synchronization code is recognized, the data word is received and stored in file X0 in synchronization with the (asynchronous) incoming signal.

Next, the format code stored in the format code register 33, is decoded in a decode circuit 54 to determine which of the possible sixteen format codes is present. Typically, and preferably, the first format code encountered will be "0". This orders the loading of constants relating to the display from file register X0 to file register X3. File X3, which was illustrated in Fig. 3, is also shown in Fig. 4. When format code 0 is recognized by the format decode circuit 54, an enablement signal is provided on connection 56 to enable the file X3 to receive the constants from the file X0. The constants include the KH factor, which is stored in the KH register 38, the meter identification number, which is stored in an identification number register 41, and a display time, which is stored in the display time register 39, as well as other flags and constants required for the operation of the system.

While the format decode logic is used for the transfer of constants to file X3, that transfer does not immediately result in an actual display of data.

The quantity KH, which is stored in register 38, is a constant associated with each watt-hour meter. For each meter, each pulse output represents a predetermined amount of energy transmitted through the power metering system. The constant KH represents that predetermined amount for a particular meter. KH is one of the quantities which is to be displayed. KH is also a factor by which the pulse count must be multiplied to derive a correct energy reading.

The quantities which are to be displayed are ultimately stored in the display memory 36, which is a part of the file X1 illustrated in Fig. 3, and which is shown again in Fig. 4. The quantities stored in display memory 36 must be subsequently converted to the seven segment display code by means of a code converter 58, before being supplied through the connection bus 16 to the display device 14.

The quantities to be displayed are transfered to the display memory register 36 by means of a format control circuit 60. The format control circuit 60 typically receives data from the scratch register 34 through the connections indicated at 61, modifies that data, if necessary, and then transmits it on to the display memory 36. The format control 60 is operable in response to appropriate signals from the format decode circuit 54, such as through control connections 62.

In the case of energy measurements, the format control 60 receives a count of pulses from the watt-hour meter through the scratch register 34. That count of pulses must be multiplied by the factor KH which is obtainable from the KH register 38 through the connections indicated at 64. Accordingly, in this instance, the format control operates as a multiplier to provide the resulting product to the display memory 36.

In other instances, other format changes are required from the format control circuit 60. For instance, when the format code is "4", it is necessary to convert the data from binary to binary coded decimal.

The length of time for which each quantity is displayed may be specified as one of the constants stored in file X3 in time register 39. This display time specification is supplied to a display time control circuit 70, which is connected, as indicated at 72, to control the display time of operation of the display 14.

The representations of components other than the storage files and storage registers in Fig. 4 are schematic in nature, and additional logic gates and timing gates and timing signals may be required in order to provide reliable operation. Also, the logical functions may be carried out by general logical circuitry within the display processor, operating under the control of logic programs in which different operations may be provided by the same components operating in a programmed sequence.

## Claims

1. A multi-format data display apparatus (10) comprising:
means (K4) for accepting data words (24) in the form of a series of asynchronous digital data bits, each data word including a sync code portion (28) comprising a predetermined pattern of serial data bits and a variable length message portion (26), means (X0) for separately storing separate segments of said message portion including a message length indicating segment (31) and a format code segment (32) and a variable length data segment;
means (40, 44, 48) for recognizing said predetermined sync code patterns;
first register means (X0) for storing said message portion after recognizing said predetermined sync code pattern;
means (54) for decoding the format code segment of said stored message portions; characterized by the provision of
second register means (X3) for storing preselected constants (38, 39, 41) contained in the data segment of a stored message portion having a first predetermined format code;
third register means (36) for storing data to be displayed;
means (60) for formatting data contained in the data segment of a stored message portion having another predetermined format code which is different from said first format code, said data format being determined by the value of said other format code;
means (60) for transferring said formatted data into said third register means; and
means (14) for displaying the formated data stored in said third register means.

2. Apparatus as claimed in Claim 1 further characterized by the provision that said means (60) for formatting data includes means for multiplying the data contained in the data segment of a received message portion by a preselected stored constant.

3. Apparatus as claimed in Claim 1 or Claim 2 further characterized in that said means for displaying the formatted data comprises a nine-digit, seven segment display (14).

4. Apparatus as claimed in Claim 1 or Claim 2 further characterized in that said means (60) for formatting data includes means for converting binary data contained in the data segment of a received message portion into binary coded decimal data.

5. Apparatus as claimed in Claim 1 or Claim 2 further characterized in that there is provided means (70) for controlling said display means (14) to display said preselected formatted data for a length of time which is determined by the value of one of said stored constants (39).

## Patentansprüche

1. Multiformat-Datenanzeigeeinrichtung (10) enthaltend:
Mittel (K4) zum Annehmen von Datenwörtern (24) in der Form einer Reihe asynchroner digitaler Datenbits, wobei jedes Datenwort einen Synchronisierungskodeabschnitt (28) enthält, der ein vorbestimmtes Muster serieller Datenbits und einen Nachrichtenabschnitt (26) variabler Länge aufweist, Mittel (X0) zum getrennten Speichern getrennter Segmente des Nachrichtenabschnittes enthaltend ein die Nachrichtenlänge anzeigendes Segment (31) und ein Formatkodesegment (32) und ein Datensegment variabler Länge,

Mittel (40, 44, 48) zum Erkennen vorbestimmter Synchronisierungskodemuster,

erste Registermittel (X0) zum Speichern des Nachrichtenabschnittes nach Erkennen des vorbestimmten Synchronisierungskodemusters,

Mittel (54) zum Dekodieren des Formatkodesegmentes der gespeicherten Nachrichtenabschnitte, gekennzeichnet durch

zweite Registermittel (X3) zum Speichern vorbestimmter Konstanten (38, 39, 41), die in dem Datensegment eines gespeicherten Nachrichtenabschnittes mit einem vorbestimmten Formatkode enthalten sind,

dritte Registermittel (36) zum Speichern anzuzeigender Daten,

Mittel (60) zum Formatieren von Daten, die in dem Datensegment eines gespeicherten Nachrichtenabschnittes mit einem anderen vorbestimmten Formatkode enthalten sind, der sich von dem ersten Formatkode unterscheidet, wobei das Datenformat durch den Wert des anderen Formatkodes bestimmt ist,

Mittel (60) zum Übertragen der formatierten Daten in das dritte Registermittel, und

Mittel (14) zum Anzeigen der formatierten Daten, die in dem dritten Registermittel gespeichert sind.

2. Einrichtung nach Anspruch 1, dadurch gekennzeichnet, daß die Einrichtung (60) zum Formatieren von Daten Mittel aufweist, zum Multiplizieren der Daten, die in dem Datensegment eines empfangenen Nachrichtenabschnittes enthalten sind, mit einer vorgewählten gespeicherten Konstanten.

3. Einrichtung nach Anspruch 1 oder 2, dadurch gekennzeichnet, daß das Mittel zum Anzeigen der formatierten Daten eine 9-Ziffern, 7-Segment-Anzeige (14) aufweist.

4. Einrichtung nach Anspruch 1 oder 2, dadurch gekennzeichnet, daß das Mittel (60) zum Formatieren von Daten Mittel aufweist zum Umwandeln binärer Daten, die in dem Datensegment eines empfangenen Nachrichtenabschnittes enthalten sind, in binär-kodierte Dezimaldaten.

5. Einrichtung nach Anspruch 1 oder 2, dadurch gekennzeichnet, daß Mittel (70) vorgesehen sind zum Steuern der Anzeigeeinrichtung (14), um die vorgewählten formatierten Daten für eine Zeitdauer anzuzeigen, die durch den Wert von einer der gespeicherten Konstanten (39) bestimmt ist.

**Revendications**

1. Appareil d'affichage de données multi-formats (10), comprenant:

un moyen (K₄) pour accepter des mots (24) comprenant des données sous la forme d'une série de bits d'information numériques asynchrones, chaque mot comprenant des données comportant une partie à code de synchronisation (28) comprenant une configuration prédéterminée de bits d'information sériels et une partie (26) à message de longueur variable, un moyen (X0) pour stocker séparément des segments séparés de la partie à message comprenant un segment (31) indiquant une longueur de message, et un segment (32) sur le code du format et un segment sur les données de longueur variable;

des moyens (40, 44, 48) pour reconnaître les configurations prédéterminées du code de synchronisation;

un premier moyen de registre (X0) pour stocker la partie à message après reconnaissance de la configuration prédéterminée du code de synchronisation;

un moyen (54) pour décoder le segment sur le code de format des parties stockées à message, caractérisé par la fourniture de:

un second moyen de registre (X3) pour stocker des constantes presélectionnées (38, 39, 41) contenues dans le segment à donnée d'une partie stockée d'un message ayant un premier code prédéterminée de format;

un troisième moyen de registre (36) pour stocker des données devant être affichées;

un moyen (60) pour formater des données contenues dans le segment à donnée d'une partie stockée à message ayant un autre code prédéterminé de format qui est différent du premier code de format, ce format de données étant déterminé par la valeur de l'autre code de format;

un moyen (60) pour transférer la donnée formatée au troisième moyen de registre; et

un moyen (14) pour afficher la donnée formatée stockée dans le troisième moyen de registre.

2. Appareil selon la revendication 1, caractérisé en outre par le fait que le moyen (60) pour formater les données comprend un moyen pour multiplier la donnée contenue dans le segment à donnée d'une partie à message reçue par une constante présélectionnée stockée.

3. Appareil selon la revendication 1 ou la revendication 2, caractérisé en outre en ce que le moyen pour afficher la donnée formatée comprend un dispositif d'affichage (14) à sept segments, neuf chiffres.

4. Appareil selon la revendication 1 ou la revendication 2, caractérisé en outre en ce que le moyen (60) pour formater les données comprend un moyen pour convertir des données binaires contenues dans le segment à donnée d'une partie de message reçue en donnée décimale codée en binaire.

5. Appareil selon la revendication 1 ou la revendication 2, caractérisé en outre en ce qu'on prévoit un moyen (70) pour commander le moyen d'affichage (14) pour l'affichage de la donnée formatée présélectionnée pendant une durée qui est déterminée par la valeur de l'une des constantes stockées (39).

FIG.1

From output data selector: DATA → K4, CLOCK → K8, OFF (22)

From power supply: SUPPLY VOLTAGE (20) → SWITCH (62) → V_DD (18)

TO CPU { RDY ← CLOCK ← R9

DISPLAY PROCESSOR/ CONTROLLER (12)

Outputs: 00, 01, 02, 03, 04, 05, 06, 07, R8, R7, R6, R5, R4, R3, R2, R1, R0

9 DIGIT DISPLAY (14)

A, B, C, D, E, F, G, H

R8 R7 R6 R5 R4 R3 R2 R1 R0

16, 10

0 076 810

DATA WORD 24

MESSAGE 26

SYNC CODE

NUMBER OF NIBBLES

FORMAT CODE

DATA (UP TO TEN NIBBLES)

LSD

MSD

28

30

32

000001

LSB MSB | LSB MSB | LSB MSB | LSB MSB | LSB MSB | LSB MSB | LSB MSB | LSB MSB | LSB MSB | LSB MSB | LSB MSB | LSB MSB

NIBBLE (4 BITS)

ERROR CHECK BIT

FIG.2

| X\Y | 0 | 1 | 2 | 3 | 4 | 5 | 6 | 7 | 8 | 9 | 10. | 11 | 12 | 13 | 14 | 15 |
|---|---|---|---|---|---|---|---|---|---|---|---|---|---|---|---|---|
| 0 | NIBBLE COUNT 31 | FORMAT CODE 33 | INPUT SCRATCH REGISTER 34 | | | | | | | | | | BIT COUNT REGISTER | WORD COUNT REGISTER | MEMORY | ZERO COUNT REGISTER |
| 1 | DISPLAY MEMORY 36 — LSD … MSD | | | | | | | | | | | | | | | |
| 2 | | | | | | | | | | | | | | | | |
| 3 | KH REGISTER 38 (LSD … MSD) | | | | | | | ID REGISTER 41 (LSD MSD) | | | | DISP TIME REGISTER 39 | | | | |

FIG.3

0 076 810

FIG. 4